(19)

(11) **EP 2 342 254 B1**

(12) **EUROPÄISCHE PATENTSCHRIFT**

(45) Veröffentlichungstag und Bekanntmachung des Hinweises auf die Patenterteilung:
**27.09.2017 Patentblatt 2017/39**

(21) Anmeldenummer: **09778754.3**

(22) Anmeldetag: **29.09.2009**

(51) Int Cl.:
***C08G 18/48*** (2006.01) ***C08G 18/67*** (2006.01)
***C08G 18/78*** (2006.01) ***C08G 18/42*** (2006.01)
***C08G 18/77*** (2006.01) *G03F 7/027* (2006.01)
*G11B 7/245* (2006.01) *G03F 7/00* (2006.01)
*G03F 7/09* (2006.01) *G11B 7/26* (2006.01)
*G03F 7/035* (2006.01)

(86) Internationale Anmeldenummer:
**PCT/EP2009/006984**

(87) Internationale Veröffentlichungsnummer:
**WO 2010/037515 (08.04.2010 Gazette 2010/14)**

(54) **MEDIEN FÜR VOLUMENHOLOGRAPHISCHE AUFZEICHNUNG BASIEREND AUF SICH SELBSTENTWICKELNDEM POLYMER**

MEDIA FOR VOLUME-HOLOGRAPHIC RECORDING BASED ON SELF-DEVELOPING POLYMERS

SUPPORTS POUR L'ENREGISTREMENT HOLOGRAPHIQUE DE VOLUMES À BASE DE POLYMÈRE À DÉVELOPPEMENT AUTOMATIQUE

(84) Benannte Vertragsstaaten:
**AT BE BG CH CY CZ DE DK EE ES FI FR GB GR HR HU IE IS IT LI LT LU LV MC MK MT NL NO PL PT RO SE SI SK SM TR**

(30) Priorität: **01.10.2008 EP 08017279**

(43) Veröffentlichungstag der Anmeldung:
**13.07.2011 Patentblatt 2011/28**

(73) Patentinhaber: **Covestro Deutschland AG**
**51373 Leverkusen (DE)**

(72) Erfinder:
- **HAGEN, Rainer**
  **51377 Leverkusen (DE)**
- **STOECKEL, Nicolas**
  **50733 Köln (DE)**
- **BRUDER, Friedrich-Karl**
  **47802 Krefeld (DE)**
- **DEUBER, François**
  **50969 Köln (DE)**
- **ROELLE, Thomas**
  **51381 Leverkusen (DE)**
- **FÄCKE, Thomas**
  **51375 Leverkusen (DE)**
- **WEISER, Marc-Stephan**
  **51379 Leverkusen (DE)**
- **HÖNEL, Dennis**
  **53909 Zülpich (DE)**

(74) Vertreter: **Levpat**
**c/o Covestro AG**
**Gebäude 4825**
**51365 Leverkusen (DE)**

(56) Entgegenhaltungen:
**WO-A-03/014178** **WO-A-03/023520**
**WO-A-2008/125199** **US-A1- 2007 072 124**

Anmerkung: Innerhalb von neun Monaten nach Bekanntmachung des Hinweises auf die Erteilung des europäischen Patents im Europäischen Patentblatt kann jedermann nach Maßgabe der Ausführungsordnung beim Europäischen Patentamt gegen dieses Patent Einspruch einlegen. Der Einspruch gilt erst als eingelegt, wenn die Einspruchsgebühr entrichtet worden ist. (Art. 99(1) Europäisches Patentübereinkommen).

EP 2 342 254 B1

Printed by Jouve, 75001 PARIS (FR)

## Beschreibung

Die vorliegende Erfindung betrifft neuartige selbstentwickelnde Folien zur Einbelichtung von Volumenhologrammen, ein Verfahren zu deren Herstellung sowie deren Verwendung.

Ein Volumenhologramm wird hergestellt, indem zwei Lichtwellen gleicher Wellenlänge, auch Objektstrahl und Referenzstrahl genannt, zur Interferenz gebracht und ein holographisches Aufzeichnungmedium, in der Regel ein photographischer Film, mit dem entstehenden Interferenzmuster, das i.d.R. ein Intensitätsmuster ist, belichtet wird. Der holographische Belichtungsprozess und die Vervielfältigung des Hologramms (Replikation) sind technisch komplexe optische Verfahren, die spezielle anwendungstechnische Kenntnisse erfordern. Methoden zur Erzeugung von Hologrammen und die Theorie sind in der Literatur umfassend beschrieben [Howard M. Smith, "Principles of Holography", Wiley (1969)] [Fred Unterseher, et al. "Holography Handbook: Making Holograms the Easy Way", Ross Books (1982)] [Graham Saxby, "Practical Holography", Inst. of Physics Pub. (2004)].

Bekannte Aufzeichungsmaterialien mit unterschiedlichem Eigenschaftsprofil und Anwendungsgebiet sind: Silberhalogenid-Emulsionen, gehärtete Dichromat-Gelatine, ferroelektrische Kristalle, photochrome und dichriode Materialien sowie Photopolymere [Howard M. Smith, "Principles of Holography", Wiley (1969).]. Für Anwendungen mit hohen Stückzahlen sind nur solche Materialien von Interesse, die vor der Belichtung als stabiler Film vorliegen und somit problemlos in die Anlagen zur Hologrammherstellung und -vervielfältigung integriert werden können und die eine einfache holgraphische Belichtung und Entwicklung ermöglichen. Photopolymere gelten aufgrund ihrer trockenen Chemie, ihrer einfachen Handhabung und ihrer guten Lagerstabilität als besonders bevorzugt. Die bekanntesten Photopolymere stammen von DuPont, z.B. Omnidex HRF 600 [S. M. Schultz, et al."Volume grating preferential-order focusing waveguide coupler," Opt. Lett., vol. 24, pp. 1708-1710, Dec. 1999.] Omnidex-Materialien gehört zu der Klasse der sich selbstentwickelnden Photopolymerfilme basierend auf radikalischer Polymerisation und Monomerdiffusion [EP 0324480].

Omnidex-Photopolymere wurden im Laufe der Jahre weiterentwickelt, primär mit dem Ziel, den Brechungsindexkontrast zu erhöhen und im Film einen hohen Beugungswirkungsgrad zu erzielen [US 4942112] [DE 69032682]. Dennoch werden die anwendungstechnisch relevanten Beugungswirkungsgrade von deutlich über 2/3 durch einen hohen Anteil an thermoplastischem Binder und damit hohem Lösemittelanteil erkauft, der zu einer starken, i.d.R. unkontrollierten Abnahme der Filmdicke bei der Filmherstellung führt. Zudem ist eine thermische Nachbehandlung ("Tempern") des belichteten und UV-fixierten Photopolymeren nötig, um den maximalen Brechungsindexkontrast zu erzielen [DE 68905610]. Das Tempern ist ein zusätzlicher Verarbeitungsschritt, der die Hologrammherstellung verkompliziert und verteuert und zudem die Wahl der Trägermaterialien auf nicht temperaturempfindliche einschränkt.

Andere Photopolymer-Materialien für die Volumenholographie wurden von Polariod [US 5759721], Fuji Photo Film [EP 1510862], Konica Minolta Medical & Graphic [US 2005058911], Dai Nippon Printing [EP 1231511], Nippon Paint [EP 211615], Nissan Chemical Industries [US 20050068594], Xetos [WO 2003036389A] und InPhase Technologies [US 2002142227] entwickelt. Der Stand der Technik weist Photopolymere aus, die sich durch ihre holographischen Eigenschaften oder ihre Verarbeitung von Omnidex unterscheiden. Der technische Fortschritt wird dokumentiert durch verringerte Sauerstoffempfindlichkeit, reduzierten Materialschrumpf während der Belichtung, angepasste spektrale Empfindlichkeit (Sensitivität), lösemittelfreie Filmherstellung, höheren Beugungswirkungsgrad ohne Tempern und/oder bessere Temperatur- und Lagerstabilität.

WO 2008/125199 A offenbart aromatische Urethanacrylate, die einen hohen Brechungsindex aufweisen.

US 2007/072124 A1 offenbart Zusammensetzungen zur optischen Aufnahme umfassend eine Matrix und ein Monomer, sowie ein Medium zur optischen Aufnahme.

WO 03/023520 A offenbart holographische Photopolymer-Datenaufnahme-Medien, ein Herstellungsverfahren und ein Verfahren zur holographischen Auslesen, Aufnehmen und Speichern von Daten.

WO 03/014178 A offenbart ein Verfahren und eine Zusammensetzung geeignet zur Massenproduktion von Gegenständen zur holographischen Aufnahme.

Photopolymerfilme, die Volumenhologramme lichtbeständig und zeitlich stabil speichern, müssen nach dem Stand der Technik thermisch nachbehandelt werden und/oder zeigen holographische Verluste, hervorgerufen durch Absorption, Streuung, Schrumpf oder mangelnde Oberflächenqualität, die die Intensität der Hologramme verringert oder deren Farbe verändert.

Echte selbstentwickelnde, Photopolymerfilme mit hoher Effizienz und ausreichender Stabilität sind nach wie vor Gegenstand intensiver Forschung.

Es wurde nun überraschenderweise gefunden, das sich selbstentwickelnde, Photopolymerfilme mit hoher Effizienz und ausreichender Stabilität gerade dann erhalten lassen, wenn man eine spezielle Kombination von Trägermaterial und Photopolymerzusammensetzung basierend auf einer Matrix, die ein polymeres Netzwerk darstellt und mindestens einem darin gelösten photopolymerisierbaren Monomer verwendet.

Die Erfindung ist durch die angefügten Ansprüche definiert.

Gegenstand der vorliegenden Erfindung ist daher ein Medium geeignet zur Aufzeichnung von Hologrammen umfassend

I) als Träger eine Lage eines für Licht im sichtbaren Spektralbereich (Transmission größer als 85% im Wellenlängenbereich von 400 bis 780 nm) transparenten Materials oder Materialverbunds, die gegebenenfalls ein- oder beidseitig beschichtet sein kann und

II) wenigstens eine auf dem Träger I) aufgebrachten gegebenenfalls mehrschichtige Photopolymerlage basierend auf Polyurethanzusammensetzungen
umfassend

A) eine Polyisocyanatkomponente,

B) eine isocyanatreaktive Komponente,

C) Verbindungen, die unter Einwirkung aktinischer Strahlung mit ethylenisch ungesättigten Verbindungen unter Polymerisation reagierende Gruppen (strahlenhärtende Gruppen) aufweisen und selbst frei von NCO-Gruppen sind,

D) Photoinitiatoren

E) Radikalstabilisatoren

F) gegebenenfalls Katalysatoren

G) gegebenenfalls Hilfs- und Zusatzstoffe,

dadurch gekennzeichnet, dass die Polyurethanzusammensetzungen der Photopolymerlagen II) eine Gesamtoberflächenspannung besitzen, die kleiner ist als die des Trägers I) einschließlich eventueller Beschichtungen darauf, wobei der Träger I) eine Doppelbrechung ausgedrückt über die mittlere optische Retardation von weniger als 1000 nm aufweist, wobei die Retardation mit einem bildgebenden Polarimeter gemessen wird, wobei die Materialien oder Materialverbünde der Trägerschicht I) auf Polycarbonat (PC), Polyethylenterephthalat (PET), Polybutylenterephthalat, Polyethylen, Polypropylen, Celluloseacetat, Cellulosehydrat, Cellulosenitrat, Cycloolefinpolymere, Polystyrol, Polyepoxide, Polysulfon, Cellulosetriacetat (CTA), Polyamid, Polymethylmethacrylat, Polyvinylchlorid, Polyvinylbutyral oder Polydicyclopentadien oder deren Mischungen basieren und wobei die Polyurethanzusammensetzungen in Komponente C) ein oder mehrere Verbindungen der Formeln (I) bis (III) umfassen:

S O P O O R X O N H NH X O R O N H R X

Formel (I)

Formel (II)

Formel (III)

wobei

R unabhängig voneinander jeweils eine strahlenhärtbare Gruppe und

X unabhängig voneinander jeweils eine Einfachbindung zwischen R und C=O oder ein linearer, verzweigter oder cyclischer gegebenenfalls heteroatomhaltiger und/oder gegebenenfalls durch funktionelle Gruppen substituierter Kohlenwassertoffrest ist.

Zur Ermittlung der Transparenz wird die Transmission mittels eines UV-/VIS-Spektrometers z.B. der Firma Varian, Model Spektrophotometer Cary 4G, verwendet. Die Messung wird durchgeführt, indem die Materialprobe in senkrechter Inzidenz in Transmission gegen Luft gemessen wird.

Als transparent werden im Rahmen der vorliegenden Erfindung Materialien oder Materialverbünde angesehen, bei denen die Transmission bevorzugt mindestens 90 %, besonders bevorzugt wenigstens 95% beträgt.

Unter aktinischer Strahlung wird elektromagnetische, ionisierende Strahlung verstanden, insbesondere Elektronenstrahlen, UV-Strahlen sowie sichtbares Licht (Roche Lexikon Medizin, 4.Auflage; Urban & Fischer Verlag, München 1999).

Materialien oder Materialverbünde der Trägerschicht I) basieren auf Polycarbonat (PC), Polyethylenterephthalat (PET), Polybutylenterephthalat, Polyethylen, Polypropylen, Celluloseacetat, Cellulosehydrat, Cellulosenitrat, Cycloolefinpolymere, Polystyrol, Polyepoxide, Polysulfon, Cellulosetriacetat (CTA), Polyamid, Polymethylmethacrylat, Polyvinylchlorid, Polyvinylbutyral oder Polydicyclopentadien oder deren Mischungen. Besonders bevorzugt basieren sie auf PC, PET und CTA.

Materialverbünde können Folienlaminate oder Coextrudate sein. Bevorzugte Materialverbünde sind Duplex- und Triplexfolien aufgebaut nach einem der Schemata A/B, A/B/A oder A/B/C. Besonders bevorzugt sind PC/PET, PET/PC/PET und PC/TPU (TPU = Thermoplastisches Polyurethan).

Auch offenbart ist, dass alternativ zu den vorgenannten Kunststoffträgern auch planare Glasplatten eingesetzt werden können, die insbesondere für großflächige abbildungsgenaue Belichtungen Verwendung finden, z.B. für holographische Lithographie [Ng, Willie W.; Hong, Chi-Shain; Yariv, Amnon. Holographic interference lithography for integrated optics. IEEE Transactions on Electron Devices (1978), ED-25(10), 1193-1200. ISSN:0018-9383].

Bevorzugt sind transparente Träger I), die optisch klar, d.h. nicht trüb sind. Die Trübung (engl. Haze) ist messbar

über den Haze-Wert, welcher kleiner als 3,5%, bevorzugt kleiner als 1%, besonders bevorzugt kleiner als 0,3% ist.

Der Haze-Wert beschreibt den Anteil des transmittierten Lichts, der von der durchstrahlten Probe nach vorne gestreut wird. Somit ist er ein Maß für die Opazität oder Trübung transparenter Materialien und quantifiziert Materialfehler, Partikel, Inhomogenitäten oder kristalline Phasengrenzen in dem Material oder seiner Oberfläche, die die klare Durchsicht stören. Das Verfahren zur Messung der Trübung wird in der Norm ASTM D 1003 beschrieben.

Der Träger I) weist eine nicht zu hohe Doppelbrechung auf, d.h. typischerweise eine mittlere optische Retardation von weniger als 1000 nm, bevorzugt von weniger als 700 nm, besonders bevorzugt von weniger als 300 nm auf.

Die Retardation R ist das mathematische Produkt aus der Doppelbrechung $\Delta n$ und der Dicke des Trägers d. Die automatische und objektive Messung der Retardation erfolgt mit einem bildgebenden Polarimeter, z.B. von der Firma ilis GmbH, Modell StainMatic® M3/M.

Die Retardation wird in senkrechter Inzidenz gemessen. Die für den Träger I) angegebenen Werte für die Retardation sind laterale Mittelwerte.

Der Träger I) hat, einschließlich eventueller ein oder beidseitiger Beschichtungen, typischerweise eine Dicke von 5 bis 2000 µm, bevorzugt 8 bis 200 µm, besonders bevorzugt 10 bis 175 µm und insbesondere 30 bis 50 µm.

Die Materialien oder Materialverbünde des Trägers I) können einseitig oder beidseitig antihaftend, antistatisch, hydrophobiert oder hydrophiliert ausgerüstet sein. Die genannten Modifikationen dienen an der der Schicht II) zugewandten Seite dem Zweck, dass die Photopolymerlage II) von dem Träger I) zerstörungsfrei abgelöst werden kann. Eine Modifikation der der Photopolymerlage abgewandten Seite des Trägers dient dazu, dass die erfindungsgemäßen Medien speziellen mechanischen Anforderungen genügen, die z.B. bei der Verarbeitung in Rollenlaminatoren, insbesondere bei Rolle-zu-Rolle-Verfahren, gefordert sind.

Ebenfalls kann der Träger I) eine entspiegelnde, sog. anti-reflex-Schicht aufweisen, insbesondere, um unerwünschte Grenzflächenreflexe bei der holographischen Belichtung zu unterdrücken.

In einer speziellen Ausführungsform, die insbesondere zur Aufnahme von Transmissionshologrammen vorgesehen ist, umfasst der Träger I) eine spiegelnde Schicht.

In einer weiteren Ausführungsform umfasst der Träger I) rückseitig eine rückstands- und zerstörungsfrei entfernbare absorbierende Schicht. Diese hat insbesondere die Aufgabe, unerwünschte Rückseitenreflexe bei der holographischen Belichtung zu unterdrücken und kann nach Ende der holographischen Belichtung entfernt werden, so dass Träger I) seine Transparenz wieder erhält. Diese Schicht kann entweder in Form einer Beschichtung oder als in sich stabiler Kaschierfilm vorliegen. Für den Kaschierfilm werden bevorzugt Folienmaterialien analog den in der Trägerschicht eingesetzten Materialien verwendet.

In einer weiteren Ausführungsform umfasst der Träger I) einseitig eine kratz- bzw. abriebfeste Schicht. Dies schließt eine Folien-Rückseitenkaschierung mit ein, für die bevorzugt Folienmaterialien analog den in der Trägerschicht eingesetzten Materialien verwendet werden.

Die Photopolymerlagen II) haben bevorzugt eine Gesamtschichtdicke bezogen auf alle in Schicht II) aufgebrachten Photopolymerlagen von höchstens 200 µm, besonders bevorzugt 3 bis 200 µm, ganz besonders bevorzugt 5 bis 120 µm und insbesondere 10 bis 30 µm.

Die Polyurethanzusammensetzungen der Photopolymerlagen II) besitzen bevorzugt eine Gesamtoberflächenspannung, die kleiner ist als die des Trägers I) einschließlich eventueller Beschichtungen darauf. Die Gesamtoberflächenspannung wird über Randwinkelmessungen mit polaren und unpolaren Messflüssigkeiten durchgeführt, deren Oberflächenspannung (polarer und unpolarer Anteil) bekannt ist. Nach Owens und Wendt (D.K. Owens and R.C. Wendt, J. Appl. Polym. Sci. 13 (1969), pp. 1741-1747) kann daraus der unpolare und polare Anteil der zu ermittelnden Festkörperoberflächenspannung berechnet werden.

Aufgrund der geringeren Oberflächenspannung ist es möglich Schichten der Photopolymerlagen II) insbesondere im vorgenannten Dickenbereich und mit guter Oberflächenqualität zu erzielen.

Ferner führt dies zu im gesamten sichtbaren Spektralbereich (Wellenlängen 400 - 800 nm) nutzbaren, und in Teilen des nahen UV-Bereiches (300-400 nm) transparenten Filmen, die als Photopolymer für die Darstellung von kontrastreichen Hologrammen im Sinne der Erfindung genutzt werden können.

Besonders bevorzugt ist die Oberflächenspannung der Polyurethanzusammensetzungen um mindestens 1 mN/m, ganz besonders bevorzugt um mindestens 10 mN/m, insbesondere um mindestens 20 mN/m kleiner als die Oberflächenspannung des Trägers I).

Die Isocyanatkomponente A) der Photopolymerlage umfasst bevorzugt Polyisocyanate. Als Polyisocyanate können alle dem Fachmann an sich gut bekannten Verbindungen oder deren Mischungen eingesetzt werden, die im Mittel zwei oder mehr NCO-Funktionen pro Molekül aufweisen. Diese können auf aromatischer, araliphatischer, aliphatischer oder cycloaliphatischer Basis sein. In untergeordneten Mengen können auch Monoisocyanate und/oder ungesättigte Gruppen enthaltende Polyisocyanate mitverwendet werden.

Beispielsweise geeignet sind Butylendüsocyanat, Hexamethylendiisocyanat (HDI), Isophorondiisocyanat (IPDI), 1,8-Diisocyanato-4-(isocyanatomethyl)-octan, 2,2,4- und/oder 2,4,4-Trimethylhexamethylendiisocyanat, die isomeren Bis-(4,4'-isocyanatocyclohexyl)methan und deren Mischungen beliebigen Isomerengehalts, Isocyanatomethyl-l,8-octandiisocyanat, 1,4-Cyclohexylendiisocyanat, die isomeren Cyclohexandimethylendüsocyanate, 1,4-Phenylendiisocyanat, 2,4- und/oder 2,6-Toluylendiisocyanat, 1,5-Naphthylendiisocyanat, 2,4'- oder 4,4'-Diphenylmethandiisocyanat und/oder Triphenylmethan-4,4,4"-triisocyanat.

Ebenfalls möglich ist der Einsatz von Derivaten monomerer Di- oder Triisocyanate mit Urethan-, Harnstoff-, Carbodiimid-, Acylharnstoff-, Isocyanurat-, Allophanat-, Biuret-, Oxadiazintrion-, Uretdion- und/oder Iminooxadiazindionstrukturen.

Bevorzugt ist der Einsatz von Polyisocyanaten auf Basis aliphatischer und/oder cycloaliphatischer Di- oder Triisocyanate.

Besonders bevorzugt handelt es sich bei den Polyisocyanaten der Komponente A) um di- oder oligomerisierte aliphatische und/oder cycloaliphatische Di- oder Triisocyanate.

Ganz besonders bevorzugt sind Isocyanurate, Uretdione und/oder Iminooxadiazindione basierend auf HDI, 1,8-Diisocyanato-4-(isocyanatomethyl)-oktan oder deren Mischungen.

Als Komponente B) können an sich alle polyfunktionellen, isocyanatreaktiven Verbindungen eingesetzt werden, die im Mittel wenigstens 1,5 isocyanatreaktive-Gruppen pro Molekül aufweisen.

Isocyanatreaktive Gruppen im Rahmen der vorliegenden Erfindung sind bevorzugt Hydroxy-, Amino- oder Thiogruppen, besonders bevorzugt sind Hydroxyverbindungen.

Geeignete polyfunktionelle, isocyanatreaktive Verbindungen sind beispielsweise Polyester-, Polyether-, Polycarbonat-, Poly(meth)acrylat- und/oder Polyurethanpolyole.

Als Polyesterpolyole sind beispielsweise lineare Polyesterdiole oder verzweigte Polyesterpolyole geeignet, wie sie in bekannter Weise aus aliphatischen, cycloaliphatischen oder aromatischen Di- bzw. Polycarbonsäuren bzw. ihren Anhydriden mit mehrwertigen Alkoholen einer OH-Funktionalität ≥ 2 erhalten werden.

Beispiele für solche Di- bzw. Polycarbonsäuren bzw. Anhydride sind Bernstein-, Glutar-, Adipin-, Pimelin-, Kork-, Azelain-, Sebacin-, Nonandicarbon-, Decandicarbon-, Terephthal-, Isophthal-, o-Phthal-, Tetrahydrophthal-, Hexahydrophthal- oder Trimellitsäure sowie Säureanhydride wie o-Phthal-, Trimellit- oder Bernsteinsäureanhydrid oder deren beliebige Gemische untereinander.

Beispiele für solche geeigneten Alkohole sind Ethandiol, Di-, Tri-, Tetraethylenglykol, 1,2-Propandiol, Di-, Tri-, Tetrapropylenglykol, 1,3-Propandiol, Butandiol-1,4, Butandiol-1,3, Butandiol-2,3, Pentandiol-1,5, Hexandiol-1,6, 2,2-Dimethyl-1,3-propandiol, 1,4-Dihydroxycyclohexan, 1,4-Dimethylolcyclohexan, Octandiol-1,8, Decandiol-1,10, Dodecandiol-1,12, Trimethylolpropan, Glycerin oder deren beliebige Gemische untereinander.

Die Polyesterpolyole können auch auf natürlichen Rohstoffen wie Rizinusöl basieren. Ebenfalls möglich ist, dass die Polyesterpolyole auf Homo- oder Mischpolymerisaten von Lactonen basieren, wie sie bevorzugt durch Anlagerung von Lactonen bzw. Lactongemischen wie Butyrolacton, ε-Caprolacton und/oder Methyl-ε-caprolacton an hydroxyfunktionelle Verbindungen wie mehrwertige Alkohole einer OH-Funktionalität ≥ 2 beispielsweise der vorstehend genannten Art erhalten werden können.

Solche Polyesterpolyole haben bevorzugt zahlenmittlere Molmassen von 400 bis 8000 g/Mol, besonders bevorzugt von 500 bis 4000 g/Mol. Ihre OH-Funktionalität beträgt bevorzugt 1,5 bis 3,5, besonders bevorzugt 1,8 bis 3,0.

Geeignete Polycarbonatpolyole sind in an sich bekannter Weise durch Umsetzung von organischen Carbonaten oder Phosgen mit Diolen oder Diol-Mischungen zugänglich.

Geeignete organische Carbonate sind Dimethyl-, Diethyl- und Diphenylcarbonat.

Geeignete Diole bzw. Mischungen umfassen die an sich im Rahmen der Polyestersegmente genannten mehrwertigen Alkoholen einer OH-Funktionalität ≥ 2, bevorzugt 1,4-Butandiol, 1,6-Hexandiol und/oder 3-Methylpentandiol, oder auch Polyesterpolyole können zu Polycarbonatpolyolen umgearbeitet werden.

Solche Polycarbonatpolyole haben bevorzugt zahlenmittlere Molmassen von 400 bis 4000 g/Mol, besonders bevorzugt von 500 bis 2000 g/Mol. Die OH-Funktionalität dieser Polyole beträgt bevorzugt 1,8 bis 3,2, besonders bevorzugt 1,9 bis 3,0.

Geeignete Polyetherpolyole sind gegebenenfalls blockweise aufgebaute Polyadditionsprodukte cyclischer Ether an OH- oder NH-funktionelle Startermoleküle.

Geeignete cyclische Ether sind beispielsweise Styroloxide, Ethylenoxid, Propylenoxid, Tetrahydrofuran, Butylenoxid, Epichlorhydrin, sowie ihre beliebigen Mischungen.

Als Starter können die an sich im Rahmen der Polyesterpolyole genannten mehrwertigen Alkohole einer OH-Funktionalität ≥ 2 sowie primäre oder sekundäre Amine und Aminoalkohole verwendet werden.

Solche Polyetherpolyole haben bevorzugt zahlenmittlere Molmassen von 250 bis 10000 g/Mol, besonders bevorzugt von 500 bis 8500 g/Mol und ganz besonders bevorzugt von 600 bis 4500 g/Mol. Die OH-Funktionalität beträgt bevorzugt 1,5 bis 4,0, besonders bevorzugt 1,8 bis 3,0.

Daneben sind als Bestandteile der Komponente B) als polyfunktionelle, isocyanatreaktive Verbindungen auch niedermolekulare, d.h. mit Molekulargewichten kleiner 500 g/mol, kurzkettige, d.h. 2 bis 20 Kohlenstoffatome enthaltende aliphatische, araliphatische oder cycloaliphatische di, tri oder polyfunktionelle Alkohole geeignet.

Dies können beispielsweise sein Ethylenglykol, Diethylenglykol, Triethylenglykol, Tetraethylenglykol, Dipropylenglykol, Tripropylenglykol, 1,2-Propandiol, 1,3-Propandiol, 1,4-Butandiol, Neopentylglykol, 2-Ethyl-2-butylpropandiol, Trimethylpentandiol, stellungsisomere Diethyloctandiole, 1,3-Butylenglykol, Cyclohexandiol, 1,4-Cyclohexandimethanol, 1,6-Hexandiol, 1,2- und 1,4-Cyclohexandiol, hydriertes Bisphenol A (2,2-Bis(4-hydroxycyclohexyl)propan), 2,2-Dimethyl-3-hydroxypropionsäure(2,2-dimethyl-3-hydroxypropylester). Beispiele geeigneter Triole sind Trimethylolethan, Trimethylolpropan oder Glycerin. Geeignete höherfunktionelle Alkohole sind Ditrimethylolpropan, Pentaerythrit, Dipentaerythrit oder Sorbit.

Bevorzugte Komponenten B) sind Poly(propylenoxid)e, Poly(ethylenoxide) und deren Kombinationen in Form von statistischen oder Blockcopolymeren sowie Blockcopolymere aus Propylenoxid und/oder Ethylenoxid, die zusätzlich Tetrahydrofuran, Butylenoxid oder ε-Caprolacton als Monomereinheiten enthalten sowie Mischungen derselben mit einer OH-Funktionalität von 1,5 bis 6 und einer zahlenmittleren Molmasse zwischen 200 und 18000 g/Mol, besonders bevorzugt mit einer OH-Funktionalität von 1,8 bis 4,0 und einer zahlenmittleren Molmasse zwischen 600 und 8000 g/Mol und ganz besonders bevorzugt mit einer OH-Funktionalität von 1,9 bis 3,1 und einer zahlenmittleren Molmasse zwischen 650 und 4500 g/Mol.

Auch offenbart ist, dass in Komponente C) Verbindungen wie α,β-ungesättigte Carbonsäurederivate wie Acrylate, Methacrylate, Maleinate, Fumarate, Maleimide, Acrylamide, weiterhin Vinylether, Propenylether, Allylether und Dicyclopentadienyl-Einheiten enthaltende Verbindungen sowie olefinisch ungesättigte Verbindungen wie z.B. Styrol, α-Methylstyrol, Vinyltoluol, Olefinine, wie z.B. 1-Octen und/oder 1-Decen, Vinylestern, (Meth)acrylnitril, (Meth)acrylamid, Methacrylsäure, Acrylsäure eingesetzt werden können. Bevorzugt sind Acrylate und Methacrylate.

Als Acrylate bzw. Methacrylate werden allgemein Ester der Acrylsäure bzw. Methacrylsäure bezeichnet. Beispiele verwendbarer Acrylate und Methacrylate sind Methylacrylat, Methylmethacrylat, Ethylacrylat, Ethylmethacrylat, Ethoxyethylacrylat, Ethoxyethylmethacrylat, n-Butylacrylat, n-Butylmethacrylat, tert.-Butylacrylat, tert.-Butylmethacrylat, Hexylacrylat, Hexylmethacrylat, 2-Ethylhexylacrylat, 2-Ethylhexylmethacrylat, Butoxyethylacrylat, Butoxyethylmethacrylat, Laurylacrylat, Laurylmethacrylat, Isobornylacrylat, Isobornylmethacrylat, Phenylacrylat, Phenylmethacrylat, p-Chlorphenylacrylat, p-Chlorphenylmethacrylat, p-Bromphenylacrylat, p-Bromphenylmethacrylat, 2,4,6-Trichlorphenylacrylat, 2,4,6-Trichlorphenylmethacrylat, 2,4,6-Tribromphenylacrylat, 2,4,6-Tribromphenylmethacrylat, Pentachlorphenylacrylat, Pentachlorphenylmethacrylat, Pentabromphenylacrylat, Pentabromphenylmethacrylat, Pentabrombenzylacrylat, Pentabrombenzylmethacrylat, Phenoxyethylacrylat, Phenoxyethylmethacrylat, Phenoxyethoxyethylacrylat, Phenoxyethoxyethylmethacrylat, 2-Naphthylacrylat, 2-Naphthylmethacrylat, 1,4-Bis-(2-thionaphthyl)-2-butylacrylat, 1,4-Bis-(2-thionaphthyl)-2-butylmethacrylat, Propan-2,2-diylbis[(2,6-dibrom-4,1-phenylen)oxy(2-{[3,3,3-tris(4-chlorphenyl)-propanoyl]-oxy}propan-3,1-diyl)oxyethan-2,1-diyl]-diacrylat, Bisphenol A Diacrylat, Bisphenol A Dimethacrylat, Tetrabromobisphenol A Diacrylat, Tetrabromobisphenol A Dimethacrylat sowie deren ethoxylierte Analogverbindungen, N-Carbazolylacrylate um nur eine Auswahl verwendbarer Acrylate und Methacrylate zu nennen.

Selbstverständlich können auch Urethanacrylate als Komponente C) verwendet werden. Unter Urethanacrylaten versteht man Verbindungen mit mindestens einer Acrylsäureestergruppe die zusätzlich über mindestens eine Urethanbindung verfügen. Es ist bekannt, dass solche Verbindungen durch Umsetzung eines Hydroxy-funktionellen Acrylsäureesters mit einer Isocyanatfunktionellen Verbindung erhalten werden können.

Beispiele hierfür verwendbarer Isocyanate sind aromatische, araliphatische, aliphatische und cycloaliphatische Di-, Tri- oder Polyisocyanate. Es können auch Mischungen solcher Di-, Tri- oder Polyisocyanate eingesetzt werden. Beispiele geeigneter Di-, Tri- oder Polyisocyanate sind Butylendiisocyanat, Hexamethylendiisocyanat (HDI), Isophorondiisocyanat (IPDI), 1,8-Diisocyanato-4-(isocyanatomethyl)oktan, 2,2,4- und/oder 2,4,4-Trimethylhexamethylendiisocyanat, die isomeren Bis(4,4'-isocyanatocyclohexyl)methane und deren Mischungen beliebigen Isomerengehalts, Isocyanatomethyl-1,8-octandüsocyanat, 1,4-Cyclohexylendüsocyanat, die isomeren Cyclohexandimethylendiisocyanate, 1,4-Phenylendiisocyanat, 2,4- und/oder 2,6-Toluylendiisocyanat, 1,5-Naphthylendiisocyanat, 2,4'- oder 4,4'-Diphenylmethandiisocyanat, 1,5-Naphthylendiisocyanat, Triphenylmethan-4,4',4"-triisocyanat und Tris(p-isocyanatophenyl)thiophosphat oder deren Derivate mit Urethan-, Harnstoff-, Carbodiimid-, Acylharnstoff-, Isocyanurat-, Allophanat-, Biuret-, Oxadiazintrion-, Uretdion-, Iminooxadiazindionstruktur und Mischungen derselben. Bevorzugt sind dabei aromatische oder araliphatische Di-, Tri- oder Polyisocyanate.

Als hydroxyfunktionelle Acrylate oder Methacrylate für die Herstellung von Urethanacrylaten kommen beispielsweise in Betracht Verbindungen wie 2-Hydroxyethyl(meth)acrylat, Polyethylenoxid-mono(meth)acrylate, Polypropylenoxidmono(meth)acrylate, Polyalkylenoxidmono(meth)-acrylate, Poly(ε-caprolacton)mono(meth)acrylate, wie z.B. Tone® M100 (Dow, Schwalbach, DE), 2-Hydroxypropyl(meth)acrylat, 4-Hydroxybutyl(meth)acrylat, 3-Hydroxy-2,2-dimethylpropyl-(meth)acrylat, Hydroxypropyl(meth)acrylat, Acrylsäure-(2-hydroxy-3-phenoxypropylester), die hydroxyfunktionellen Mono-, Di- oder Tetraacrylate mehrwertiger Alkohole wie Trimethylolpropan, Glycerin, Pentaerythrit, Dipentaerythrit, ethoxyliertes, propoxyliertes oder alkoxyliertes Trimethylolpropan, Glycerin, Pentaerythrit, Dipentaerythrit oder deren technische Gemische. Bevorzugt sind 2-Hydroxyethylacrylat, Hydroxypropylacrylat, 4-Hydroxybutylacrylat und Poly(ε-caprolacton)mono(meth)acrylate. Darüber hinaus sind als isocyanat-reaktive oligomere oder polymere ungesättigte Acrylat- und/oder Methacrylatgruppen enthaltende Verbindungen alleine oder in Kombination mit den vorgenannten monomeren Verbindungen geeignet. Ebenfalls verwendet werden können die an sich bekannten hydroxylgruppenhaltigen Epoxy(meth)acrylate mit OH-Gehalten von 20 bis 300 mg KOH/g oder hydroxylgruppenhaltige Polyurethan(meth)acrylate mit OH-Gehalten von 20 bis 300 mg KOH/g oder acrylierte Polyacrylate mit OH-Gehalten von 20 bis 300 mg KOH/g sowie deren Mischungen untereinander und Mischungen mit hydroxylgruppenhaltigen ungesättigten Polyestern sowie Mischungen mit Polyester(meth)acrylaten oder Mischungen hydroxylgruppenhaltiger ungesättigter Polyester mit Polyester(meth)acrylaten. Bevorzugt sind hydroxylgruppenhaltige Epoxyacrylate mit definierter Hydroxyfunktionalität. Hydroxylguppenhaltige Epoxy(meth)acrylate basieren insbesondere auf Umsetzungsprodukten von Acrylsäure und/oder Methacrylsäure mit Epoxiden (Glycidylverbindungen) von monomeren, oligomeren oder polymeren Bisphenol-A, Bisphenol-F, Hexandiol und/oder Butandiol oder deren ethoxylierten und/oder propoxylierten Derivaten. Bevorzugt sind weiterhin Epoxyacrylate mit definierter Funktionalität wie sie aus der bekannten Umsetzung von Acrylsäure und/oder Methacrylsäure und Glycidyl(meth)acrylat erhalten werden können.
Bevorzugt werden in Komponente C) Verbindungen mit Vinylether-, Acrylat- oder Methacrylat-Gruppe, besonders bevorzugt Acrylat- und/oder Methacrylatgruppen eingesetzt.

Bevorzugt werden in C) Verbindungen der vorstehend genannten Art mit einem Brechungsindex von größer 1,55, besonders bevorzugt 1,58 eingesetzt.

Erfindungsgemäß umfasst die Schreibmonomerkomponente C) ein oder mehrere Verbindungen der Formeln (I) bis (III):

Formel (I)

Formel (II)

Formel (III)

wobei

R unabhängig voneinander jeweils eine strahlenhärtbare Gruppe und

X unabhängig voneinander jeweils eine Einfachbindung zwischen R und C=O oder ein linearer, verzweigter oder cyclischer gegebenenfalls heteroatomhaltiger und/oder gegebenenfalls durch funktionelle Gruppen substituierter Kohlenwassertoffrest ist.

Bevorzugt ist R eine Vinylether-, Acrylat- oder Methacrylat-Gruppe, besonders bevorzugt eine Acrylatgruppe.

Grundsätzlich können einzelne oder mehrere der kohlenstoffgebundenen Wasserstoffatome der Gruppe R auch durch $C_1$- bis $C_5$-Alkylgruppen ersetzt sein, was allerdings nicht bevorzugt ist.

Bevorzugt weist die Gruppe X 2 bis 40 Kohlenstoffatome sowie ein oder mehrere in Form von Etherbrücken vorliegende Sauerstoffatome auf. X kann dabei sowohl linear als auch verzweigt oder cyclisch sowie durch funktionelle Gruppen substituiert sein. Besonders bevorzugt ist die Gruppe X jeweils eine lineare oder verzweigte Oxyalkylen- oder Polyoxyalkylengruppe.

Bevorzugte Polyoxyalkylengruppen weisen bis zu 10., bevorzugt bis zu 8, Wiederholungseinheiten der jeweiligen Oxyalkylengruppe auf.

Grundsätzlich ist es möglich, dass X gleiche oder verschiedene Oxyalkylengruppen als Wiederholungseinheiten aufweist, wobei eine solche Wiederholungseinheit bevorzugt 2 bis 6, besonders bevorzugt 2 bis 4 Kohlenstoffatome aufweist. Besonders bevorzugte Oxyalkyleneinheiten sind Oxyethylen sowie jeweils die isomeren Oxypropylene oder Oxybutylene.

Die Wiederholungseinheiten innerhalb der jeweiligen Gruppe X können dabei ganz oder teilweise blockweise oder statistisch verteilt vorliegen.

In einer bevorzugten Ausführungsform der Erfindung ist X unabhängig voneinander jeweils eine Oxyalkyleneinheit ausgewählt aus der Gruppe bestehend aus $-CH_2-CH_2-O-$, $-CH_2-CHCH_3-O-$, $-CHCH_3-CH_2-O-$, $-(CH_2-CH_2-O)_n-$, $-O(CH_2-CHCH_3-O)_n$ wobei n eine ganze Zahl von 2 bis 7 ist, und $-O-CH_2-CH_2-(O-(CH_2)_5-CO)_m-$, wobei m eine ganze Zahl von 1 bis 5 ist.

Als Komponente D) werden ein oder mehrere Photoinitiatoren eingesetzt. Dies sind üblicherweise durch aktinische Strahlung aktivierbare Initiatoren, die eine Polymerisation der entsprechenden polymerisierbaren Gruppen auslösen. Photoinitiatoren sind an sich bekannte, kommerziell vertriebene Verbindungen, wobei zwischen unimolekularen (Typ I) und bimolekularen (Typ II) Initiatoren unterschieden wird. Desweiteren werden diese Initiatoren je nach chemischer Natur für die radikalische, die anionische (oder), die kationische (oder gemischte) Formen der vorgenannten Polymerisationen eingesetzt.

(Typ I)-Systeme für die radikalische Photopolymerisation sind z.B. aromatische Ketonverbindungen, z.B. Benzophenone in Kombination mit tertiären Aminen, Alkylbenzophenone, 4,4'-Bis(dimethylamino)benzophenon (Michlers Keton), Anthron und halogenierte Benzophenone oder Mischungen der genannten Typen. Weiter geeignet sind (Typ II)-Initiatoren wie Benzoin und seine Derivate, Benzilketale, Acylphosphinoxide z.B. 2,4,6-Trimethyl-benzoyl-diphenylphosphinoxid, Bisacylophosphinoxid, Phenylglyoxylsäureester, Campherchinon, alpha-Aminoalkylphenon, alpha-,alpha-Dialkoxyacetophenon, 1-[4-(Phenylthio)phenyl]octan-1,2-dion-2-(O-benzoyloxim) und alpha-Hydroxyalkylphenon. Auch die in EP-A 0223587 beschriebenen Photoinitiatorsysteme bestehend aus einer Mischung aus einem Ammoniumarylborat und einem oder mehreren Farbstoffen können als Photoinitiator eingesetzt werden. Als Ammoniumarylborat eignen sich beispielsweise Tetrabutylammonium Triphenylhexylborat, Tetrabutylammonium Tris-(3-fluorphenyl)-hexylborat und Tetrabutylammonium Tris-(3-Chlor-4-methylphenyl)-hexylborat. Als Farbstoffe eignen sich beispielsweise Neu-Methylenblau, Thionin, Basic Yellow, Pinacynol Chlorid, Rhodamin 6G, Gallocyanin, Ethylviolett, Victoria Blue R, Celestine Blue, Chinaldinrot, Kristallviolett, Brilliant Grün, Astrazon Orange G, Darrow Red, Pyronin Y, Basic Red 29, Pyrillium I, Cyanin und Methylenblau, Azur A (Cunningham et al., RadTech'98 North America UV/EB Conference Proceedings, Chicago, Apr. 19-22, 1998).

Die für die anionische Polymerisation verwendeten Photoinitiatoren sind in der Regel (Typ I)-Systeme und leiten sich von Übergangsmetall-Komplexen der ersten Reihe ab. Hier sind ChromSalze, wie z.B. trans-$Cr(NH_3)_2(NCS)_4^-$ (Kutal et al, Macromolecules 1991, 24, 6872) oder Ferrocenyl-Verbindungen (Yamaguchi et al. Macromolecules 2000, 33, 1152) bekannt. Eine weitere Möglichkeit der anionischen Polymerisation besteht in der Verwendung von Farbstoffen, wie Kristallviolett Leukonitril oder Malchit Grün Leukonitril, die durch photolytischen Zerfall Cyanoacrylate polymerisieren können (Neckers et al. Macromolecules 2000, 33, 7761). Allerdings wird dabei das Chromophor in das Polymer eingebaut, so dass die resultierenden Polymere durchgefärbt sind.

Die für die kationische Polymerisation verwendeten Photoinitiatoren bestehen im wesentlichen aus drei Klassen: Aryldiazonium-Salze, Onium-Salze (hier speziell: Iodonium-, Sulfonium- und Selenonium-Salze) sowie Organometall-Verbindungen. Phenyldiazonium-Salze können unter Bestrahlung sowohl in Gegenwart als auch in Abwesenheit eines Wasserstoff-Donors ein Kation erzeugten, dass die Polymerisation initiiert. Die Effizienz des Gesamtsystems wird durch

die Natur des verwendeten Gegenions zur Diazonium-Verbindung bestimmt. Bevorzugt sind hier die wenig reaktiven aber recht teuren $SbF_6^-$, $AsF_6^-$ oder $PF_6^-$. Für den Einsatz in Beschichtung dünner Filme sind diese Verbindungen i.d.R wenig geeignet, da durch den nach der Belichtung freigesetzten Stickstoff die Oberflächegüte herabgesetzt wird (pinholes) (Li et al., Polymeric Materials Science and Engineering, 2001, 84, 139). Sehr weit verbreitet und auch in vielerlei Form kommerziell erhältlich sind Onium-Salze, speziell Sulfonium- und Iodonium-Salze. Die Photochemie dieser Verbindungen ist nachhaltig untersucht worden. Die Iodonium-Salze zerfallen nach der Anregung zunächst homolytisch und erzeugen somit ein Radikal und ein Radikalkation, welches sich durch H-Abstraktion stabilisiert, ein Proton freisetzt und dann die kationische Polymerisation startet (Dektar et al. J. Org. Chem. 1990, 55, 639; J. Org. Chem., 1991, 56, 1838). Dieser Mechanismus ermöglicht den Einsatz von Iodonium-Salzen ebenfalls für die radikalische Photopolymerisation. Hierbei kommt erneut der Wahl des Gegenions eine große Bedeutung zu, bevorzugt werden ebenfalls die recht teuren $SbF_6^-$, $AsF_6^-$ oder $PF_6^-$. Ansonsten ist in dieser Strukturklasse die Wahl der Substitution des Aromaten recht frei und im wesentlichen durch die Verfügbarkeit geeigneter Startbausteine für die Synthese bestimmt. Bei den Sulfonium-Salzen handelt es sich um Verbindungen, die nach Norrish(II) zerfallen (Crivello et al., Macromolecules, 2000, 33, 825). Auch bei den Sulfonium-Salzen kommt der Wahl des Gegenions eine kritische Bedeutung zu, die sich im Wesentlichen in der Härtungsgeschwindigkeit der Polymere äußert. Die besten Ergebnisse werden i.d.R. mit $SbF_6^-$ Salzen erzielt. Da die Eigenabsorption von Iodonium- und Sulfonium-Salze bei <300nm liegt, müssen diese Verbindungen für die Photopolymerisation mit nahem UV oder kurzwelligem sichtbarem Licht entsprechend sensibilisiert werden. Dies gelingt durch die Verwendung von höher absorbierenden Aromaten wie z.B. Anthracen und Derivaten (Gu et al., Am. Chem. Soc. Polymer Preprints, 2000, 41 (2), 1266) oder Phenothiazin bzw. dessen Derivaten (Hua et al, Macromolecules 2001, 34, 2488-2494).

Es kann vorteilhaft sein auch Gemische dieser Verbindungen einzusetzen. Je nach zur Härtung verwendeter Strahlungsquelle muss Typ und Konzentration an Photoinitiator in dem Fachmann bekannter Weise angepasst werden. Die vorgenannte Einstellung hinsichtlich der Photopolymerisation ist für einen Fachmann in Form von Routineversuchen innerhalb der unten angegebenen Mengenbereiche der Komponenten sowie der jeweils zur Auswahl stehenden, insbesondere den bevorzugten Aufbaukomponenten, leicht möglich.

Bevorzugte Photoinitiatoren D) sind Mischungen aus Tetrabutylammonium Tetrahexylborat, Tetrabutylammonium Triphenylhexylborat, Tetrabutylammonium Tris-(3-fluorphenyl)-hexylborat und Tetrabutylammonium Tris-(3-Chlor-4-methylphenyl)-hexylborat mit Farbstoffen wie beispielsweise Astrazon Orange G, Methylenblau, Neu Methylenblau, Azur A, Pyrillium I, Safranin O, Cyanin, Gallocyanin, Brilliant Grün, Kristallviolett, Ethylviolett und Thionin.

Ferner können die erfindungsgemäßen Formulierungen neben den Komponenten A) bis C) auch Radikalstabilisatoren, Katalysatoren und weitere Zusatzstoffe mit eingesetzt werden.

Als Radikalstabilisatoren E) geeignet sind Inhibitoren und Antioxidantien wie sie in "Methoden der organischen Chemie" (Houben-Weyl), 4. Auflage, Band XIV/1, S. 433ff, Georg Thieme Verlag, Stuttgart 1961, beschrieben sind. Geeignete Stoffklassen sind beispielsweise Phenole wie z.B. 2,6-Di-tert-butyl-4-methylphenol, Kresole, Hydrochinone, Benzylalkohole wie z.B. Benzhydrol, ggf. auch Chinone wie z. B. 2,5-Di-tert.-Butylchinon, ggf. auch aromatische Amine wie Diisopropylamin oder Phenothiazin. Bevorzugte Radikalstabilisatoren sind 2,6-Di-tert.-butyl-4-methylphenol, Phenothiazin und Benzhydrol.

Ferner können ein oder mehrere Katalysatoren F) eingesetzt werden. Diese katalysieren bevorzugt die Urethanbildung. Dazu sind bevorzugt Amine sowie Metallverbindungen der Metalle Zinn, Zink, Eisen, Bismuth, Molybdän, Kobalt, Calzium, Magnesium und Zirkonium geeignet. Besonders bevorzugt sind Zinnoctoat, Zinkoktoat, Dibutylzinndilaurat, Dimethylzinndicarboxylat, Eisen(III)-acetylacetonat, Eisen(II)-chlorid, Zinkchlorid, Tetra-alkyl-ammoniumhydroxide, Alkalihydroxide, Alkalialkoholate, Alkalisalze von langkettigen Fettsäuren mit 10 bis 20 Kohlenstoffatomen und gegebenenfalls seitenständigen OH-Gruppen, Bleioctoat oder tertiäre Amine wie Triethylamin, Tributylamin, Dimethylbenzylamin, Dicyclohexylmethylamin, Dimethyl-cyclohexylamin, N,N,N',N'-Tetramethyl-diamino-diethylether, Bis-(dimethylamino-propyl)-harnstoff, N-Methyl- bzw. N-Ethylmorpholin, N,N'-Dimorpholinodiethylether (DMDEE), N-Cyclohexylmorpholin, N,N,N',N'-Tetramethylethylendiamin, N,N,N',N'-Tetramethyl-butan-diamin, N,N,N',N'-Tetramethylhexandiamin-1,6, Pentamethyldiethylentriamin, Dimethylpiperazin, N-Dimethylaminoethylpiperidin, 1,2-Dimethylimidazol, N-Hydroxypropylimidazol, 1-Azabicyclo-(2,2,0)-octan, 1,4-Diazabicyclo-(2,2,2)-octan (Dabco) oder Alkanolaminverbindungen, wie Triethanolamin, Triisopropanolamin, N-Methyl- und N-Ethyl-diethanolamin, Dimethyl-amino-ethanol, 2-(N,N-Dimethylaminoethoxy)ethanol oder N-Tris-(dialkylaminoalkyl)hexa-hydro-triazine, z.B. N,N',N-Tris-(dimethylaminopropyl)-s-hexahydrotriazin 1,4-Diazabicyclo-[2.2.2]-octan, Diazabicyclononan, Diazabicycloundecan, 1,1,3,3-Tetramethylguanidin, 1,3,4,6,7,8-Hexahydro-1-methyl-2H-pyrimido(1,2-a)pyrimidin.

Besonders bevorzugte Katalysatoren sind Dibutylzinndilaurat, Dimethylzinndicarboxylat, Eisen(III)acetylacetonat, 1,4-Diazabicyclo-[2.2.2]-octan, Diazabicyclononan, Diazabicycloundecan, 1,1,3,3-Tetramethylguanidin, 1,3,4,6,7,8-Hexahydro-1-methyl-2H-pyrimido(1,2-a)pyrimidin.

Als weitere Hilfs- und Zusatzstoffe G) können beispielsweise enthalten sein Lösemittel, Weichmacher, Verlaufsmittel, Benetzungsmittel, Entschäumer oder Haftvermittler, aber auch Polyurethane, thermoplastische Polymere, Oligomere, weitere funktionelle Gruppen, wie z.B. Acetale, Epoxid, Oxetane, Oxazoline, Dioxolane und/oder hydrophile

Gruppen, wie z.B. Salze und/oder Polyethylenoxide, aufweisende Verbindungen.

Als Lösemittel werden dabei bevorzugt leichtflüchtige Lösemittel mit guter Verträglichkeit mit den erfindungswesentlichen Formulierungen verwendet, beispielsweise Ethylacetat, Butylacetat, Aceton.

Als Weichmacher werden dabei bevorzugt Flüssigkeiten mit guten Löseeigenschaften, geringer Flüchtigkeit und hoher Siedetemperatur eingesetzt.

Es kann auch von Vorteil sein, gleichzeitig mehrere Zusatzstoffe eines Typs zu verwenden. Selbstverständlich kann es ebenfalls von Vorteil sein, mehrere Zusatzstoffe mehrerer Typen zu verwenden.

Zusätzlich zu den Bestandteilen I) und II) können die erfindungsgemäßen Medien ein oder mehrere Abdeckschichten III) auf der oder den Photopolymerlagen II) aufweisen, um diese vor Schmutz und Umwelteinflüssen zu schützen. Hierzu können Kunststofffolien oder Folienverbundsysteme, aber auch Klarlacke oder planare Glasplatten verwendet werden.

Als Abdeckschichten III) werden bevorzugt Folienmaterialien analog den in der Trägerschicht eingesetzten Materialien verwendet, wobei diese eine Dicke von typischerweise 5 bis 200 $\mu$m, bevorzugt 8 bis 125 $\mu$m, besonders bevorzugt 10 bis 50 $\mu$m.

Bevorzugt sind Abdeckschichten III) mit einer möglichst glatten Oberfläche. Als Maß gilt die Rauigkeit bestimmt nach DIN EN ISO 4288 "Geometrische Produktspezifikation (GPS) - Oberflächenbeschaffenheit..." (engl. "Geometrical Product Specifications (GPS) - Surface texture...", Prüfbedingung R3z Vorderseite und Rückseite. Bevorzugte Rauigkeiten liegen im Bereich kleiner oder gleich 2 $\mu$m, bevorzugt kleiner oder gleich 0,5 $\mu$m.

Sind die Abdeckschichten III) optisch transparent für die Lichtquelle, die im holographischen Belichtungsprozess Verwendung findet, d.h. zeigen hohe Transmissionsgrade von typischerweise größer als 80%, so können diese bereits vor der holographischen Belichtung auf das erfindungsgemäße Medium aufgebracht sein und auch während der holographischen Belichtung im Medium verbleiben. Sind diese nicht transparent, so muss die holographische Belichtung i.d.R. ohne die Abdeckschichten III) erfolgen. Das erfindungsgemäße Medium ist dann mit der nicht transparenten Abdeckschicht nach der holographischen Belichtung zu versehen.

Die Methode zur Ermittlung der Transparenz ist oben beschrieben.

Eine bevorzugte Ausführungsform des erfindungsgemäßen Mediums ist der Transferfolienverbund, in welchem die Photopolymerlage(n) (II) auf andere Oberflächen transferiert werden können, insbesondere in industriellen Fertigungsverfahren wie Rolle-zu-Rolle-Verfahren unter Verwendung von Laminations-, Klebe- oder anderer Fügetechnik.

Besagte Ausführungsform ist dadurch gekennzeichnet, dass die Abdeckschicht III) bestehend aus einer Kunststofffolie oder einem Folienverbundsystem mit geringem Kraftaufwand vollflächig von der oder den Photopolymerlagen II) entfernt werden kann. Der Haftverbund von Trägerfolie I) und Photopolymerlage/Photopolymerlagen II) ist dabei etwas stärker als der von Photopolymerlage/Photopolymerlagen II) und Abdeckschicht III), so dass Photopolymerlage/Photopolymerlagen II) bei besagtem Entfernen der Abdeckschicht III) vollständig und zerstörungsfrei auf der Trägerfolie I) verbleiben.

Der Transferieren der Photopolymerlage(n) geschieht in Einzelschritten wie folgt: Zunächst wird die Abdeckschicht III) vom Medium entfernt. Im Anschluss kann dieser Verbund mit der offenen Photopolymerlage auf andere beliebige Oberflächen transferiert werden. Insbesondere zeichnet diesen Folienverbund erstens eine höchstmöglichste Haftung zwischen Photopolymer und Trägerfolie I) aus, um einen stabilen Folienverbund zu gewährleisten, aber zweitens eine niedrigstmögliche Haftung, so dass diese Trägerfolie nach dem Laminier- oder Klebeprozess entfernt werden kann und das Photopolymer zerstörungsfrei auf der neuen Oberfläche verbleibt.

Ein weiterer Gegenstand der vorliegenden Erfindung ist ein Verfahren zur Herstellung der erfindungsgemäßen Medien geeignet zur Aufzeichnung von Hologrammen, bei dem auf einen Träger I) ein oder mehrere Photopolymerlagen II) oben beschriebener Zusammensetzung aufgebracht werden, appliziert und ausgehärtet werden.

Die Komponenten A) und B) werden dabei in einem OH/NCO-Verhältnis zueinander eingesetzt von typischerweise 0,5 bis 2,0, bevorzugt 0,95 bis 1,50, besonders bevorzugt 0,97 bis 1,33.

Das erfindungsgemäße Verfahren wird bevorzugt derart durchgeführt, dass die Aufbaukomponenten der erfindungswesentlichen Polyurethanzusammensetzung mit Ausnahme der Komponente A) miteinander homogen vermischt werden und unmittelbar vor der Applikation auf das Substrat oder in die Form der Komponente A) zugemischt wird.

Zur Vermischung können alle dem Fachmann aus der Mischungstechnik an sich bekannten Verfahren und Apparate, wie beispielsweise Rührkessel oder sowohl dynamische als auch statische Mischer verwendet werden. Bevorzugt sind allerdings Apparate ohne oder mit nur geringen Toträumen. Weiterhin sind Verfahren bevorzugt, in denen die Vermischung innerhalb sehr kurzer Zeit und mit sehr starker Durchmischung der beiden zu mischenden Komponenten erfolgt. Hierfür eignen sich insbesondere dynamische Mischer, insbesondere solche, in denen die Komponenten erst im Mischer miteinander in Kontakt kommen.

Die Temperaturen betragen dabei 0 bis 100 °C, bevorzugt 10 bis 80 °C, besonders bevorzugt 20 bis 60 °C, ganz besonders bevorzugt 20 bis 40°C.

Falls notwendig kann auch eine Entgasung der einzelnen Komponenten oder der gesamten Mischung unter einem reduzierten Druck von beispielsweise 1 mbar durchgeführt werden. Ein Entgasen, insbesondere nach Zugabe

der Komponente A) ist bevorzugt, um Blasenbildung durch Restgase in den erhältlichen Medien zu verhindern.

Vor Zumischung der Komponente A) können die Mischungen als lagerstabiles Zwischenprodukt gegebenenfalls über mehrere Monate gelagert werden kann.

Nach der Zumischung der Komponente A) wird eine klare, flüssige Formulierung erhalten, die je nach Zusammensetzung bei Raumtemperatur innerhalb weniger Sekunden bis zu einigen Stunden aushärtet.

Das Verhältnis sowie die Art und Reaktivität der Aufbaukomponenten wird bevorzugt so eingestellt, dass die Aushärtung nach Zumischung der Komponente A) bei Raumtemperatur innerhalb von Minuten bis zu einer Stunde eintritt. In einer bevorzugten Ausführungsform wird die Aushärtung beschleunigt indem die Formulierung nach der Zumischung auf Temperaturen zwischen 30 und 180 °C, bevorzugt 40 bis 120 °C, besonders bevorzugt 50 bis 100 °C erwärmt wird.

Die vorgenannte Einstellung hinsichtlich des Aushärteverhaltens ist für einen Fachmann leicht in Form von Routineversuchen innerhalb der oben angegebenen Mengenbereich der Komponenten sowie der jeweils zur Auswahl stehenden, insbesondere den bevorzugten Aufbaukomponenten, leicht möglich.

Die erfindungswesentlichen Polyurethanzusammensetzungen besitzen unmittelbar nach vollständiger Vermischung aller Komponenten Viskositäten bei 25°C von typischerweise 10 bis 100000 mPas, bevorzugt 100 bis 20000 mPas, besonders bevorzugt 200 bis 15000 mPas, insbesondere bevorzugt 500 bis 10000 mPas so dass sie bereits in lösemittelfreier Form sehr gute verarbeitungstechnische Eigenschaften besitzen. In Lösung mit geeigneten Lösemitteln können Viskositäten bei 25°C unterhalb 10000 mPas, bevorzugt unterhalb 2000 mPas, besonders bevorzugt unterhalb 500 mPas eingestellt werden.

Als vorteilhaft haben sich Polyurethanzusammensetzungen der vorstehend genannten Art erwiesen, die in einer Menge von 15 g und mit einem Katalysatorgehalt von 0,004 Gew.-% bei 25°C unter 4 Stunden aushärten, bzw. bei einem Katalysatorgehalt von 0,02 % in weniger als 10 Minuten bei 25°C aushärten.

Zur Applikation auf den Träger I) sind alle jeweiligen gängigen, dem Fachmann bekannten Verfahren geeignet, wie insbesondere Rakeln, Gießen, Drucken, Siebdruck, Spritzen, oder Inkjet-Druck.

Auf den erfindungsgemäßen Medien können durch entsprechende Belichtungsprozesse Hologramme für optische Anwendungen im gesamten sichtbaren Bereich inklusive des nahen UV-Bereichs (Gesamtwellenlängenfenster 300 - 800 nm) hergestellt werden. Visuelle Hologramme umfassen alle Hologramme, die nach dem Fachmann bekannten Verfahren aufgezeichnet werden können, darunter fallen unter anderem In-Line (Gabor) Hologramme, Off-Axis Hologramme, Full-Aperture Transfer Hologramme, Weißlicht-Transmissionshologramme ("Regenbogenhologramme"), Denisyuk-Hologramme, Off-Axis Reflektionshologramme, Edge-Lit Hologramme sowie Holographische Stereogramme, bevorzugt sind Reflexionshologramme, Denisyuk-Hologramme, Transmissionshologramme.

Solche Hologramme eignen sich für personalisierte Daten wie Portraits, biometrische und andere maschinenlesbare Informationen und digitale Daten in Sicherheitsdokumenten, oder allgemein für die Darstellung von Bildern oder Bildstrukturen für Werbung, Sicherheitslabels, Markenschutz, Markenbranding, Etiketten, Designelementen, Dekorationen, Illustrationen, Sammelkarten, Bilder und dergleichen sowie Bilder, die digitale Daten repräsentieren können u.a auch in Kombination mit den zuvor dargestellen Produkten. Holographische Bilder können den Eindruck eines dreidimensionalen Bildes haben, sie können aber auch Bildsequenzen, kurze Filme oder eine Anzahl von verschiedenen Objekten darstellen, je nachdem aus welchem Winkel, mit welcher (auch bewegten) Lichtquelle etc. diese beleuchtet wird. Aufgrund dieser vielfältigen Designmöglichkeiten stellen Hologramme, insbesondere Volumenhologramme, eine attraktive technische Lösung für die oben genannten Anwendung dar.

Ebenfalls möglich ist auch die Herstellung von optischen Elementen wie Linsen, Spiegel, Umlenkspiegel, Filter, Streuscheiben, Beugungselemente (z.B. holographisch-optische Elemente), Lichtleiter, Lichtlenker (z.B. holographische Beugungsgitter), Projektionsscheiben und/oder Photomasken/-platten haben. Häufig zeigen diese optischen Elemente eine Frequenzselektivität je nachdem wie die Hologramme belichtet wurden und welche Dimensionen das Holgramm hat.

## Beispiele:

Die folgenden Beispiele sind zur Erläuterung der erfindungsgemäßen Photopolymere genannt, sollen aber nicht als begrenzend verstanden sein. Sofern nicht abweichend vermerkt, beziehen sich alle Prozentangaben auf Gewichtsprozent.

## Einsatzstoffe:

### Herstellung des Urethanacrylates (Komponente C)

In einem 500 mL Rundkolben wurden 0,1 g 2,6-Di-tert.-butyl-4-methylphenol, 0,05 g Dibutylzinndilaurat (Desmorapid Z, Bayer MaterialScience AG, Leverkusen, Deutschland) sowie und 213,07 g einer 27 %-igen Lösung von Tris(p-isocyanatophenyl)thiophosphat in Ethylacetat (Desmodur® RFE, Produkt der Bayer MaterialScience AG, Leverkusen, Deutschland) vorgelegt und auf 60 °C erwärmt. Anschließend wurden 42,37 g 2-Hydroxyethylacrylat zugetropft und die Mischung weiter auf 60 °C gehalten, bis der Isocyanatgehalt unter 0,1 % gesunken war. Danach wurde abgekühlt und im Vakuum das Ethylacetat vollständig entfernt. Das Produkt wurde als teilkristalliner Feststoff erhalten.

**Herstellung der Polyol-Komponente 1:**

In einem 1 L Kolben wurden 0,18 g Zinnoktoat, 374,81 g ε-Caprolacton und 374,81 g eines difunktionellen Polytetrahydrofuranpolyetherpolyols (Equivalentgewicht 500 g/Mol OH) vorgelegt und auf 120 °C aufgeheizt und so lange auf dieser Temperatur gehalten, bis der Festgehalt (Anteil der nicht-flüchtigen Bestandteile) bei 99,5 Gew.-% oder darüber lag. Anschließend wurde abgekühlt und das Produkt als wachsiger Feststoff erhalten.

**Herstellung der Polyol-Komponente 2:**

In einem 1 L Kolben wurden 0,25 g Zinnoktoat, 374,51 g ε-Caprolacton und 141,51 g Baysilon OFOH 502 6% (ein hydroxyalkyl-funktionelles (α, ω-Carbinol) Polydimethylsiloxan) vorgelegt und auf 150 °C aufgeheizt und so lange auf dieser Temperatur gehalten, bis der Festgehalt (Anteil der nicht-flüchtigen Bestandteile) bei 99,5 Gew.-% oder darüber lag. Anschließend wurde abgekühlt und das Produkt als wachsiger Feststoff erhalten.

**Methode zur Bestimmung von DE und Δn von holografischen Formulierungen:**

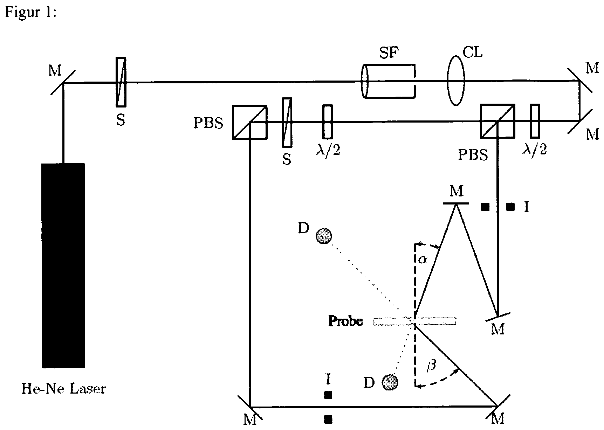

Die hergestellten Medien wurden mittels einer Messanordnung gemäß Figur 1 wie folgt auf ihre holographischen Eigenschaften DE und Δn geprüft:

Figur 1: Geometrie eines Holographic Media Testers bei λ = 633 nm (He-Ne Laser)zum Schreiben eines Reflexionshologrammes: M = Spiegel, S = Verschluss, SF = Raumfilter, CL = Kollimatorlinse, λ/2 = λ/2 Platte, PBS = polarisationsempfindlicher Strahlteiler, D = Detektor, I = Irisblende, α = 21.8° und β = 41.8° sind die Einfallswinkel der kohärenten Strahlen ausserhalb der Probe (des Mediums) gemessen.

Der Strahl eines He-Ne Lasers (Emissionswellenlänge 633 nm) wurde mit Hilfe des Raumfilter (SF) und zusammen mit der Kollimationslinse (CL) in einen parallelen homogenen Strahl umgewandelt. Die finalen Querschnitte des Signal und Referenzstrahls werden durch die Irisblenden (I) festgelegt. Der Durchmesser der Irisblendenöffnung beträgt 0.4 cm. Die polarisationsabhängigen Strahlteiler (PBS) teilen den Laserstrahl in zwei kohärente gleich polarisierte Strahlen. Über die λ/2 Plättchen wurden die Leistung des Referenzstrahls of 0.5 mW und die Leistung des Signalstrahls auf 0.65 mW eingestellt. Die Leistungen wurden mit den Halbleiterdetektoren (D) bei ausgebauter Probe bestimmt. Der Einfallswinkel (α) des Referenzstrahls beträgt 21.8°, der Einfallswinkel (β) des Signalstrahl beträgt 41.8°. Am Ort der Probe (Medium) erzeugte das Interferenzfeld der zwei überlappenden Strahlen ein Gitter heller und dunkler Streifen die senkrecht zur Winkelhalbierenden der zwei auf die Probe einfallenden Strahlen liegen (Reflexionshologramm). Der Streifenabstand Λ, auch Gitterperiode genannt, im Medium beträgt ~ 225 nm (der Brechungsindex des Mediums zu ~1.504 angenommen).

Es wurden auf folgende Weise Hologramme in das Medium geschrieben:

- Beide Shutter (S) sind für die Belichtungszeit t geöffnet.
- Danach wurde bei geschlossenen Shuttern (S) dem Medium 5 Minuten Zeit für die Diffusion der noch nicht polymerisierten Schreibmonomere gelassen.

Die geschriebenen Hologramme wurden nun auf folgende Weise ausgelesen. Der Shutter des Signalstrahls blieb geschlossen. Der Shutter des Referenzstrahls war geöffnet. Die Irisblende des Referenzstrahls wurde auf einen Durchmesser < 1 mm geschlossen. Damit erreichte man das für alle Drehwinkel (Ω) des Mediums der Strahl immer vollständig im zuvor geschriebenen Hologramm lag. Der Drehtisch überstrich nun computergesteuert den Winkelbereich von Ω = 0° bis Ω = 20° mit einer Winkelschrittweite von 0.05°. An jedem angefahrenen Winkel Ω□□□ wurden die Leistungen des in der nullten Ordnung transmittierten Strahls mittels des entsprechenden Detektors D und die Leistungen des in die erste Ordnung abgebeugten Strahls mittels des Detektors D gemessen. Die Beugungseffizienz η ergab sich bei jedem angefahrenen Winkel Ω als der Quotient aus:

$$\eta = \frac{P_D}{P_D + P_T}$$

$P_D$ ist die Leistung im Detektor des abgebeugten Strahls und $P_T$ ist die Leistung im Detektor des transmittierten Strahls.

Mittels des oben beschriebenen Verfahrens wurde die Braggkurve, sie beschreibt den Beugungswirkungsgrad $\eta$ in Abhängigkeit des Drehwinkels Ω□□ des geschriebenen Hologramms gemessen und in einem Computer gespeichert. Zusätzlich wurde auch die in die nullte Ordnung transmittierte Intensität gegen der Drehwinkel $\Omega$ aufgezeichnet und in einem Computer gespeichert.

Die maximale Beugungseffizienz (DE = $\eta_{max}$) des Hologramms, also sein Spitzenwert, wurde ermittelt. Eventuell musste dazu die Position des Detektors des abgebeugten Strahls verändert werden, um diesen maximalen Wert zu bestimmen.

Der Brechungsindexkontrast $\Delta n$ und die Dicke d der Photopolymerschicht wurde nun mittels der Coupled Wave Theorie (siehe; H. Kogelnik, The Bell System Technical Journal, Volume 48, November 1969, Number 9 Seite 2909 - Seite 2947) an die gemessene Braggkurve und den Winkelverlauf der transmittierten Intensität ermittelt. Das Verfahren wird im folgenden beschrieben:

Für die Braggkurve $\eta(\Omega)$ eines Reflexionshologramms gilt nach Kogelnik:

$$\eta = \frac{1}{1 + \frac{1 - (\chi/\Phi)^2}{\sinh^2\left(\sqrt{\Phi^2 - \chi^2}\right)}}$$

mit:

$$\Phi = \frac{\pi \cdot \Delta n \cdot d}{\lambda \cdot \sqrt{\cos(\alpha') \cdot \cos(\alpha' - 2\psi)}}$$

$$\chi = \Delta\theta \cdot \frac{2\pi \cdot \sin(\alpha' - \psi)}{\Lambda \cdot \cos(\alpha' - 2\psi)} \cdot \frac{d}{2}$$

$$\psi = \frac{\beta' - \alpha'}{2}$$

$$\Lambda = \frac{\lambda}{2 \cdot n \cdot \cos(\psi - \alpha')}$$

$$n \cdot \sin(\alpha') = \sin(\alpha),\ n \cdot \sin(\beta') = \sin(\beta)$$

$$\Delta\theta = -\Delta\Omega \cdot \sqrt{\frac{1 - \sin^2(\alpha)}{n^2 - \sin^2(\alpha)}}$$

$\Phi$ ist die Gitterstärke, $\chi$ ist der Detuning Parameter und $\psi$ der Kippwinkel des Brechungsindexgitters das geschrieben wurde. $\alpha'$ und $\beta'$ entsprechen den Winkeln $\alpha$ und $\beta$ beim Schreiben des Hologramms, aber im Medium gemessen. $\Delta\theta$ ist das Winkeldetuning gemessen im Medium, also die Abweichung vom Winkel $\alpha'$. $\Delta\Omega$ ist das Winkeldetuning gemessen ausserhalb des Mediums, also die Abweichung vom Winkel $\alpha$. n ist der mittlere Brechungsindex des Photopolymers und wurde zu 1.504 gesetzt. $\lambda$ ist die Wellenlänge des Laserlichts im Vakuum.

Die maximale Beugungseffizienz (DE = $\eta_{max}$) ergibt sich dann für $\chi = 0$, also $\Delta\Omega = 0$ zu:

$$DE = \tanh^2(\Phi) = \tanh^2\left(\frac{\pi \cdot \Delta n \cdot d}{\lambda \cdot \sqrt{\cos(\alpha') \cdot \cos(\alpha' - 2\psi)}}\right)$$

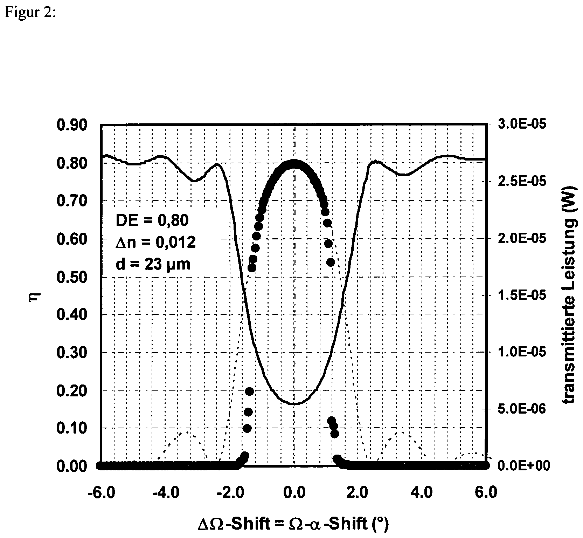

Die Messdaten der Beugungseffizienz, die theoretische Braggkurve und die transmittierte Intensität werden wie in Figure 2 gezeigt gegen den zentrierten Drehwinkel Ω-α-Shift aufgetragen. Da wegen geometrischem Schrumpf und der Änderung des mittleren Brechungsindexes bei der Photopolymerisation der Winkel bei dem DE gemessen wird von α abweicht wird die x-Achse um diesen Shift zentriert. Der Shift beträgt typischerweise 0° bis 2°.

Da DE bekannt ist wird die Form der theoretischen Braggkurve nach Kogelnik nur noch durch die Dicke d der Photopolymerschicht bestimmt. Δn wird über DE für gegebene Dicke d so nachkorrigiert, dass Messung und Theorie von DE immer übereinstimmen. d wird nun solange angepasst bis die Winkelpositionen der ersten Nebenminima der theoretischen Braggkurve mit den Winkelpositionen der ersten Nebenmaxima der transmittierten Intensität übereinstimmen und zudem die volle Breite bei halber Höhe (FWHM) für theoretische Braggkurve und die transmittierte Intensität übereinstimmen.

Da die Richtung in der ein Reflexionshologramm bei der Rekonstruktion mittels eines Ω-Scans mitrotiert, der Detektor für das abgebeugte Licht aber nur einen endlichen Winkelbereich erfassen kann, wird die Braggkurve von breiten Holgrammen (kleines d) bei einem Ω-Scan nicht vollständig erfasst, sondern nur der zentrale Bereich, bei geeigneter Detektorpositionierung. Daher wird die zur Braggkurve komplementäre Form der transmittierten Intensität zur Anpassung der Schichtdicke d zusätzlich herangezogen.

Figur 2: Darstellung der Braggkurve η nach Kogelnik (gestrichelte Linie), des gemessenen Beugungswirkungsgrades (ausgefüllte Kreise) und der transmittierten Leistung (schwarz durchgezogene Linie) gegen das Winkeldetuning ΔΩ. Da wegen geometrischem Schrumpf und der Änderung des mittleren Brechungsindexes bei der Photopolymerisation der Winkel bei dem DE gemessen wird von α abweicht wird die x-Achse um diesen Shift zentriert. Der Shift beträgt typischerweise 0° bis 2°.

Für eine Formulierung wurde diese Prozedur eventuell mehrfach für verschiedene Belichtungszeiten t an verschiedenen Medien wiederholt, um festzustellen bei welcher mittleren Energiedosis des einfallenden Laserstrahls beim Schreiben des Hologramms DE in den Sättigungswert übergeht. Die mittlere Energiedosis E ergibt sich wie folgt aus den Leistungen der zwei den Winkeln α und β zugeordneten Teilstrahlen ($P_\alpha$ = 0.50 mW und $P_\beta$ = 0.67 mW), der Belichtungszeit t und dem Durchmesser der Irisblende (0.4 cm):

$$E\,(\mathrm{mJ/cm^2}) = \frac{2 \cdot \lfloor P_\alpha + P_\beta \rfloor \cdot t\,(\mathrm{s})}{\pi \cdot 0.4^2\ \mathrm{cm}^2}$$

Die Leistungen der Teilstrahlen wurden so angepasst, dass in dem Medium bei den verwendeten Winkeln α und β, die gleiche Leistungsdichte erreicht wird.

**Methode zur Bestimmung des Randwinkels und der Gesamtoberflächenspannung:**

Es wurde eine Randwinkelmessung mit polaren und unpolaren Messflüssigkeiten durchgeführt, deren Oberflächenspannung (polarer und unpolarer Anteil) bekannt ist. Nach Owens und Wendt (D.K. Owens and R.C. Wendt, J. Appl. Polym. Sci. 13 (1969), pp. 1741-1747) kann daraus der unpolare und polare Anteil der zu ermittelden Festkörperoberflächenspannung berechnet werden.

**<u>Beispiel 1:</u>**

**Exemplarische Herstellung der isocyanatreaktiven Komponente (erfindungsgemäße Teile B und C):**

9,05 g der wie oben beschrieben hergestellten Polyol-Komponente 1 wurden mit 3,75 g Urethanacrylat aus Beispiel 1 und 0,525 g N-Ethylpyrolidon bei 50 °C gemischt, so dass eine klare Lösung erhalten wurde.

**Exemplarische Herstellung der isocyanatreaktiven Komponente (Teil B und C) inklusive Katalysator (F):**

9,05 g der wie oben beschrieben hergestellten Polyol-Komponente 2 wurden mit 3,75 g Urethanacrylat aus Beispiel 1, 0,003 g Fomrez UL 28 (Urethanisierungskatalysator, Handelsprodukt der Fa. Momentive Performance Chemicals, Wilton, CT, USA) und 0,525 g N-Ethylpyrolidon bei 50 °C gemischt, so dass eine klare Lösung erhalten wurde.

Ergebnisse aus der Messung des Randwinkels:

| Probe | Gesamtoberflächenspannung [mN/m] |
|---|---|
| PC (Makrofol® DE 1-1, 175 μm) Begussfolie, Handelsprodukt der Bayer MaterialScience AG, Leverkusen, Deutschland) | 44,4 |

(fortgesetzt)

| Probe | Gesamtoberflächenspannung [mN/m] |
|---|---|
| PC (Pokalon OG 461, 30 μm) Begussfolie, Handelsprodukt der LOFO High Tech Film GmbH, Weil am Rhein, Deutschland) | 42,1 |
| CTA (Tacphan P913 GL, 80 μm) Begussfolie, Handelsprodukt der LOFO High Tech Film GmbH, Weil am Rhein, Deutschland | 46,2 |
| PET (Hostaphan GN 36 4600, 36 μm) Begussfolie, Handelsprodukt der Mitsubishi Polyester Film GmbH, Wiesbaden, Deutschland | 48,3 |
| Isocyanatreaktive Komponente (Teil B und C) | 37 |
| Isocyanatreaktiven Komponente (Teil B und C) inklusive Katalysator (F) | 20 |

Der für die isocyanatreaktive Komponente (Teile B und C) und die isocyanatreaktive Komponente (Teile B und C) inklusive Katalysator (F) im oben beschriebenen Experiment erhaltene Wert für die Gesamtoberflächenspannung ist kleiner als die Oberflächenspannung jedes der vier ausgewählten Substratträger (Teil I des holographischen Aufzeichnungsmediums). Folglich sind die Voraussetzungen für eine gute Oberflächenqualität der Beschichtung erfüllt. Dies führt zu im gesamten sichtbaren Bereich nutzbaren transparenten Filmen, die als Photopolymer für die Darstellung von kontrastreichen Hologrammen im Sinne der obigen Beschreibung genutzt werden können.

**Beispiel 2**

Herstellung der holographischen Medien basierend auf Photopolymerformulierung mit Photoinitiatator zur Bestimmung der Performance Parameter DE und Δn:

Verwendete Einsatzstoffe für das Photopolymer:

Polymermatrix: **Komponente A:** Desmodur® XP 2599, ein Versuchsprodukt der Bayer MaterialScience AG, Leverkusen, DE, Vollallophanat von Hexandiisocyanat auf difunktionellem Polypropylenoxid mit zahlenmittlerer Molmasse von 2000 g/Mol, NCO-Gehalt: 5,6 - 6,4 %. Komponente B: difunktionelles Polypropylenoxid mit zahlenmittlerer Molmasse von 4000 g/Mol, Handelsprodukt der Bayer MaterialScience AG, Leverkusen, DE

Schreibmonomer (Komponente C): 25 % Gewichtsanteil.

Photointitiator (Komponente D): New Methylen Blue 0,10% mit CGI 909 (Versuchsprodukt der Fa. Ciba Inc., Basel, Schweiz) 1%, beides in N-Ethylpyrrolidon gelöst, Anteil N-Ethylpyrrolidon 3.5%

Verwendeter Katalysator (Komponente F): Fomrez® UL28 0,05%, Urethanisierungskatalysator, Dimethylbis[(1-oxoneodecl)oxy]stannan, Handelsprodukt der Fa. Momentive Performance Chemicals, Wilton, CT, USA (als 10%ige Lösung in N-Ethylpyrrolidon eingesetzt)
Verlaufsmittel: Byk® 310 (silikonbasiertes Oberflächenadditiv der Firma BYK-Chemie GmbH, Wesel, 25%ige Lösung in Xylol) 0,3%
Substrat: Makrofol DE 1-1 CC 175 μm (Bayer MaterialScience AG, Leverkusen, Deutschland) mit PE CHX 173 Rückseitenkaschierung (Bischoff & Klein, Deutschland)
Top Kaschierfolie: PE 40 μm glatt. (Bischoff & Klein, Deutschland)

Zur Herstellung der holografischen Medien werden im Dunkeln die Komponente B), die Komponente C) (die bereits in der Komponente B) vorgelöst sein kann) sowie gegebenenfalls die Additive in der Isocyanat reaktiven Komponente B) gegebenenfalls bei 60 °C gelöst. Dann wird die Isocyanat-Komponente A) zugegeben und wieder im Speedmixer 1 Minute gemischt. Im Folgenden wird eine Lösung der Komponente C) zugegeben und im Speedmixer erneut 1 Minute gemischt. Die erhaltene Mischung wird in ein Beschichtungswerkzeug (Rakel) auf das Makrofol-Substat appliziert. Das Rakelverfahren ist gekennzeichnet durch: Rakelabstand 60 μm, Bahngeschwindigkeit 0,7 m/min. Die Härtung der PU-Formulierung erfolgt im Trockner bei 80-100°C für 10-15 min.

Durch die Messung des Randwinkels der Komposition wurde eine Gesamtoberflächenspannung von 23,7 mN/m ermittelt.

Für das im Beispiel 2 erhaltene holographische Medium wurde für die mittlere Energiedosis E = 18 mJ/cm$^2$ ein $\Delta$n von 0.012 erhalten. Die Beugungseffizienz betrug 98% und die Schichtdicke d betrug 55 μm.

## Patentansprüche

1. Medium geeignet zur Aufzeichnung von Hologrammen umfassend

   I) als Träger eine Lage eines für Licht im sichtbaren Spektralbereich (Transmission größer als 85% im Wellenlängenbereich von 400 bis 780 nm) transparenten Materials oder Materialverbunds, die gegebenenfalls ein- oder beidseitig beschichtet sein kann und
   II) wenigstens eine auf dem Träger I) aufgebrachten gegebenenfalls mehrschichtige Photopolymerlage II) basierend auf Polyurethanzusammensetzungen umfassend

      A) eine Polyisocyanatkomponente,
      B) eine isocyanatreaktive Komponente,
      C) Verbindungen, die unter Einwirkung aktinischer Strahlung mit ethylenisch ungesättigten Verbindungen unter Polymerisation reagierende Gruppen (strahlenhärtende Gruppen) aufweisen und selbst frei von NCO-Gruppen sind,
      D) Photoinitiatoren
      E) Radikalstabilisatoren
      F) gegebenenfalls Katalysatoren
      G) gegebenenfalls Hilfs- und Zusatzstoffe,

   **dadurch gekennzeichnet, dass** die Polyurethanzusammensetzungen der Photopolymerlagen II) eine Gesamtoberflächenspannung besitzen, die kleiner ist als die des Trägers I) einschließlich eventueller Beschichtungen darauf, wobei der Träger I) eine Doppelbrechung ausgedrückt über die mittlere optische Retardation von weniger als 1000 nm aufweist, wobei die Retardation mit einem bildgebenden Polarimeter gemessen wird, wobei die Materialien oder Materialverbünde der Trägerschicht I) auf Polycarbonat (PC), Polyethylenterephthalat (PET), Polybutylenterephthalat, Polyethylen, Polypropylen, Celluloseacetat, Cellulosehydrat, Cellulosenitrat, Cycloolefinpolymere, Polystyrol, Polyepoxide, Polysulfon, Cellulosetriacetat (CTA), Polyamid, Polymethylmethacrylat, Polyvinylchlorid, Polyvinylbutyral oder Polydicyclopentadien oder deren Mischungen basieren und wobei die Polyurethanzusammensetzungen in Komponente C) ein oder mehrere Verbindungen der Formeln (I) bis (III) umfassen:

Formel (I)

Formel (II)

Formel (III)

wobei

R unabhängig voneinander jeweils eine strahlenhärtbare Gruppe und
X unabhängig voneinander jeweils eine Einfachbindung zwischen R und C=O oder ein linearer, verzweigter oder cyclischer gegebenenfalls heteroatomhaltiger und/oder gegebenenfalls durch funktionelle Gruppen substituierter Kohlenwassertoffrest ist.

2. Medien gemäß Anspruch 1, **dadurch gekennzeichnet, dass** dem Träger I) als Materialien Polycarbonat, Polyethylenterephthalat und/oder Cellulosetriacetat zugrunde liegen.

3. Medien gemäß Anspruch 1 oder 2, **dadurch gekennzeichnet, dass** dem Träger I) als Materialien oder Materialverbünden Duplex- oder Triplexfolien zugrund liegen.

4. Medien gemäß einem der Ansprüche 1 bis 3, **dadurch gekennzeichnet, dass** der Träger I) einseitig oder beidseitig antihaftend, antistatisch, hydrophobiert, hydrophiliert, kratzfest, spiegelnd oder entspiegelnd ausgerüstet ist.

5. Medien gemäß einem der Ansprüche 1 bis 4, **dadurch gekennzeichnet, dass** die Photopolymerlagen II) eine Gesamtschichtdicke bezogen auf alle in Schicht II) aufgebrachten Photopolymerlagen von höchstens 200 μm aufweisen.

6. Medien gemäß einem der Ansprüche 1 bis 5, **dadurch gekennzeichnet, dass** diese ein oder mehrere Abdeckschichten III) auf der Photopolymerlage II) umfassen.

7. Verfahren zur Herstellung von Medien geeignet zur Aufzeichnung von Hologrammen gemäß einem der Ansprüche 1 bis 6, bei dem auf einen Träger I) ein oder mehrere gegebenenfalls mehrschichtige Photopolymerlagen II) appliziert und ausgehärtet werden.

8. Verwendung von Medien gemäß einem der Anspruch 1 bis 6 als optische Elemente, Bilder oder zur Bilddarstellung oder -projektion.

9. Verfahren zur Aufzeichnung von Hologrammen, bei dem Medien gemäß einem der Ansprüche 1 bis 6 mittels Laserstahl belichtet werden.

**Claims**

1. Medium suitable for recording holograms, comprising

I) as a carrier, a stratum of a transparent material or material composite which is transparent to light in the visible spectral range (transmission greater than 85% in the wavelength range of 400 to 780 nm) and may optionally be coated on one or both sides and
II) at least one optionally multilayer photopolymer stratum II) applied to the carrier I) and based on polyurethane compositions,
comprising

A) a polyisocyanate component,
B) an isocyanate-reactive component,
C) compounds which have groups reacting under the action of actinic radiation with ethylenically unsaturated compounds with polymerization (radiation-curing groups) and which themselves are free of NCO groups,
D) photoinitiators
E) free radical stabilizers
F) optionally catalysts
G) optionally auxiliaries and additives, **characterized in that** the polyurethane compositions of the photopolymer strata II) have a total surface tension which is less than that of the carrier I), including any coatings, where the carrier I) has a birefringence, expressed via the mean optical retardation, of less than 1000 nm, where the retardation is measured using an imaging polarimeter, where the materials or material composites of the carrier layer I) are based on polycarbonate (PC), polyethylene terephthalate (PET), polybutylene terephthalate, polyethylene, polypropylene, cellulose acetate, cellulose hydrate, cellulose nitrate, cycloolefin polymers, polystyrene, polyepoxides, polysulphone, cellulose triacetate (CTA), polyamide, polymethylmethacrylate, polyvinyl chloride, polyvinyl butyral or polydicyclopentadiene or mixtures thereof, and where the polyurethane compositions in component C) comprise one or more compounds of the formulae (I) to (III):

Formula (I)

Formula (II)

Formula (III)

in which

R, independently of one another, are in each case a radiation-curable group and
X, independently of one another, are in each case a single bond between R and C=O or a linear, branched or cyclic hydrocarbon radical optionally containing heteroatoms and/or optionally substituted by functional groups.

2. Media according to Claim 1, **characterized in that** the carrier I) is based on polycarbonate, polyethylene terephthalate and/or cellulose triacetate as materials.

3. Media according to Claim 1 or 2, **characterized in that** the carrier I) is based on duplex or triplex films as materials or material composites.

4. Media according to any of Claims 1 to 3, **characterized in that** the carrier I) is treated on one or both sides to make it nontacky, antistatic, water repellent, hydrophilic, scratch-resistant, reflective or antireflective.

5. Media according to any of Claims 1 to 4, **characterized in that** the photopolymer strata II) have a total layer thickness, based on all photopolymer strata applied in layer II) of not more than 200 μm.

6. Media according to any of Claims 1 to 5, **characterized in that** they comprise one or more cover layers III) on the photopolymer stratum II).

7. Method for the production of media suitable for recording holograms according to any of Claims 1 to 6, in which one or more optionally multilayer photopolymer strata II) are applied to a carrier I) and cured.

**8.** Use of media according to any of Claims 1 to 6 as optical elements, or images or for image representation or projection

**9.** Method for recording holograms, in which media according to any of Claims 1 to 6 are exposed by means of a laser beam.

**Revendications**

**1.** Support approprié pour l'enregistrement d'hologrammes, comprenant :

I) en tant que porteur, une couche d'un matériau ou matériau composite transparent pour la lumière dans la plage spectrale visible (transmission supérieure à 85 % dans la plage de longueurs d'onde de 400 à 780 nm), qui peut éventuellement être revêtu d'un ou des deux côtés, et
II) au moins une couche de photopolymère II) éventuellement multicouche appliquée sur le porteur I), à base de compositions de polyuréthane comprenant

A) un composant polyisocyanate,
B) un composant réactif avec les isocyanates,
C) des composés qui comprennent des groupes réagissant sous l'effet d'un rayonnement actinique avec des composés éthyléniquement insaturés avec polymérisation (groupes durcissant par rayonnement) et sont eux-mêmes exempts de groupes NCO,
D) des photoinitiateurs,
E) des stabilisateurs de radicaux,
F) éventuellement des catalyseurs,
G) éventuellement des adjuvants et additifs, **caractérisé en ce que** les compositions de polyuréthane des couches de photopolymère II) présentent une tension superficielle totale qui est inférieure à celle du porteur I) y compris d'éventuels revêtements, le porteur I) présentant une biréfringence exprimée par le retard optique moyen de moins de 1 000 nm, le retard étant mesuré avec un polarimètre imageant, les matériaux ou matériaux composites de la couche de porteur I) étant à base de polycarbonate (PC), de polyéthylène téréphtalate (PET), de polybutylène téréphtalate, de polyéthylène, de polypropylène, d'acétate de cellulose, d'hydrate de cellulose, de nitrate de cellulose, de polymères de cyclooléfine, de polystyrène, de polyépoxydes, de polysulfone, de triacétate de cellulose (CTA), de polyamide, de polyméthacrylate de méthyle, de polychlorure de vinyle, de polyvinylbutyral ou de polydicyclopentadiène ou leurs mélanges, et les compositions de polyuréthane dans le composant C) comprenant un ou plusieurs composés des formules (I) à (III) :

S
O
P
O
O
O
R
X
N
H
NH
X
O
R
O
N
H
R–X

Formule (I)

Formule (II)

Formule (III)

dans lesquelles

les R représentent chacun indépendamment les uns des autres un groupe durcissable par rayonnement, et

les X représentent chacun indépendamment les uns des autres une simple liaison entre R et C=O ou un radical hydrocarboné linéaire, ramifié ou cyclique, éventuellement contenant des hétéroatomes et/ou éventuellement substitué par des groupes fonctionnels.

2. Supports selon la revendication 1, **caractérisés en ce que** le porteur I) est à base de polycarbonate, de polyéthylène téréphtalate et/ou de triacétate de cellulose en tant que matériaux.

3. Supports selon la revendication 1 ou 2, **caractérisés en ce que** le porteur I) est à base de films duplex ou triplex en tant que matériaux ou matériaux composites.

4. Supports selon l'une quelconque des revendications 1 à 3, **caractérisés en ce que** le porteur I) comprend d'un ou des deux côtés un traitement antiadhérent, antistatique, hydrophobe, hydrophile, résistant aux éraflures, réfléchissant ou anti-réfléchissant.

5. Supports selon l'une quelconque des revendications 1 à 4, **caractérisés en ce que** les couches de photopolymère II) présentent une épaisseur de couche totale, par rapport à toutes les couches de photopolymère appliquées dans la couche II), d'au plus 200 μm.

6. Supports selon l'une quelconque des revendications 1 à 5, **caractérisés en ce que** ceux-ci comprennent une ou plusieurs couches de recouvrement III) sur la couche de photopolymère II).

7. Procédé de fabrication de supports appropriés pour l'enregistrement d'hologrammes selon l'une quelconque des revendications 1 à 6, selon lequel une ou plusieurs couches de photopolymère II) éventuellement multicouches sont appliquées sur un porteur I) et durcies.

8. Utilisation de supports selon l'une quelconque des revendications 1 à 6 en tant qu'éléments optiques, écrans ou

pour la présentation ou la projection d'images.

9. Procédé d'enregistrement d'hologrammes, selon lequel des supports selon l'une quelconque des revendications 1 à 6 sont exposés à un faisceau laser.

Figur 1:

M
S
SF
CL
M
PBS
S
λ/2
PBS
λ/2
M
M
I
D
α
Probe
M
β
I
D
He-Ne Laser
M
M

Figur 2:

0.90
0.80
0.70
0.60
0.50
0.40
0.30
0.20
0.10
0.00
η
DE = 0,80
Δn = 0,012
d = 23 μm
3.0E-05
2.5E-05
2.0E-05
1.5E-05
1.0E-05
5.0E-06
0.0E+00
transmittierte Leistung (W)
-6.0
-4.0
-2.0
0.0
2.0
4.0
6.0
ΔΩ-Shift = Ω-α-Shift (°)

## IN DER BESCHREIBUNG AUFGEFÜHRTE DOKUMENTE

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

### In der Beschreibung aufgeführte Patentdokumente


- EP 0324480 A
- US 4942112 A
- DE 69032682
- DE 68905610
- US 5759721 A
- EP 1510862 A
- US 2005058911 A
- EP 1231511 A
- EP 211615 A
- US 20050068594 A
- WO 2003036389 A
- US 2002142227 A
- WO 2008125199 A
- US 2007072124 A1
- WO 03023520 A
- WO 03014178 A
- EP 0223587 A


### In der Beschreibung aufgeführte Nicht-Patentliteratur


- **HOWARD M. SMITH.** Principles of Holography. Wiley, 1969
- **FRED UNTERSEHER et al.** Holography Handbook: Making Holograms the Easy Way. Ross Books, 1982
- **GRAHAM SAXBY.** Practical Holography. Inst. of Physics Pub, 2004
- **S. M. SCHULTZ et al.** Volume grating preferential-order focusing waveguide coupler. *Opt. Lett.,* Dezember 1999, vol. 24, 1708-1710
- Roche Lexikon Medizin. Urban & Fischer Verlag, 1999
- Holographic interference lithography for integrated optics. **NG, WILLIE W. ; HONG, CHI-SHAIN ; YARIV, AMNON.** IEEE Transactions on Electron Devices. 1978, vol. 25, 1193-1200
- **D.K. OWENS ; R.C. WENDT.** *J. Appl. Polym. Sci.,* 1969, vol. 13, 1741-1747
- **CUNNINGHAM et al.** *RadTech'98 North America UV/EB Conference Proceedings,* 19. April 1998
- **KUTAL et al.** *Macromolecules,* 1991, vol. 24, 6872
- **YAMAGUCHI et al.** *Macromolecules,* 2000, vol. 33, 1152
- **NECKERS et al.** *Macromolecules,* 2000, vol. 33, 7761
- **LI et al.** *Polymeric Materials Science and Engineering,* 2001, vol. 84, 139
- **DEKTAR et al.** *J. Org. Chem.,* 1990, vol. 55, 639
- *J. Org. Chem.,* 1991, vol. 56, 1838
- **CRIVELLO et al.** *Macromolecules,* 2000, vol. 33, 825
- **GU et al.** *Am. Chem. Soc. Polymer Preprints,* 2000, vol. 41 (2), 1266
- **HUA et al.** *Macromolecules,* 2001, vol. 34, 2488-2494
- **HOUBEN-WEYL.** Methoden der organischen Chemie. Georg Thieme Verlag, 1961, vol. XIV/1, 433ff
- **H. KOGELNIK.** *he Bell System Technical Journal,* November 1969, vol. 48, 2909-2947